# EUROPÄISCHE PATENTSCHRIFT

(11) **EP 3 449 230 B1**
(45) Veröffentlichungstag und Bekanntmachung des Hinweises auf die Patenterteilung: **06.05.2020**
(21) Anmeldenummer: 17709953.8
(22) Anmeldetag: 09.03.2017
(51) Int. Cl.: G01K 7/42, G01K 13/00

(54) **SCHALTELEMENT MIT EINER TEMPERATURÜBERWACHUNG UND VERFAHREN ZUR TEMPERATURÜBERWACHUNG**
SWITCHING ELEMENT HAVING TEMPERATURE MONITORING AND METHOD FOR TEMPERATURE MONITORING
ÉLÉMENT DE COMMUTATION POURVU D'UNE SURVEILLANCE DE TEMPÉRATURE ET PROCÉDÉ DE SURVEILLANCE DE TEMPÉRATURE

(30) Priorität: 29.04.2016 DE 102016207381
(43) Veröffentlichungstag der Anmeldung: 06.03.2019
(73) Patentinhaber: Robert Bosch GmbH, 70442 Stuttgart (DE)
(72) Erfinder: JIN, Jiahang, 75417 Muehlacker (DE)
(86) Internationale Anmeldenummer: PCT/EP2017/055508
(87) Internationale Veröffentlichungsnummer: WO 2017/186391

(56) Entgegenhaltungen:
- US-A1- 2009 099 791
- US-A1- 2015 211 938

## Beschreibung

Die vorliegende Erfindung betrifft ein Schaltelement mit einer Temperaturüberwachung, ein Antriebssystem mit einem solchen Schaltelement sowie ein Verfahren zur Temperaturüberwachung. Insbesondere betrifft die vorliegende Erfindung eine Temperaturüberwachung in einem Schaltelement mit einem IGBT-Modul.

### Stand der Technik

Die Druckschrift EP 1 724 561 A2 offenbart einem Temperatursensor für ein IGBT-Modul. Das IGBT-Modul weist dabei eine Bohrung auf, die zur Befestigung des IGBT-Moduls auf einem Kühlkörper vorgesehen ist. Ein Sensorelement zur Temperaturmessung ist auf einem Trägerelement untergebracht, und das Trägerelement weist eine Form auf, um das Trägerelement flächig an dem IGBT-Modul anzubringen. US 2009/099791 A1 bezieht sich auf die Temperaturüberwachung eines Leistungsschaltelements. US 2015/211938 A1 offenbart einen Überhitzungsschutz für ein Schaltelement einer elektrischen Maschine.

Für einen elektrischen Antrieb, insbesondere in einem Elektro- oder Hybridfahrzeug, werden Drehstrommaschinen über einen Wechselrichter mit elektrischer Energie versorgt. In den Wechselrichter kommen dabei insbesondere Module mit Halbleiterschaltelementen, wie zum Beispiel bipolare Transistoren mit einem isolierten Gateanschluss (IGBT) zum Einsatz. Da die Stromtragfähigkeit eines einzelnen Transistors in einem solchen Modul beschränkt ist, können in einem IGBT-Modul mehrere Transistoren parallel geschaltet werden, um die Stromtragfähigkeit zu erhöhen.

Ferner ist bei elektrischen Antriebssystemen in der Regel ein Schaltzustand vorgesehen, bei dem das System in einem sicheren Betriebszustand geschaltet werden kann. Ein solcher sicherer Betriebszustand ist zum Beispiel ein aktiver Kurzschluss, bei dem alle Phasenanschlüsse einer angeschlossenen elektrischen Maschine beispielsweise über die Schaltelemente des Wechselrichters elektrisch verbunden, also kurzgeschlossen werden können. Bei einem solchen aktiven Kurzschluss können dabei gegebenenfalls relativ hohe Ströme auftreten. Mittels eines Temperatursensors kann dabei die Temperatur des IGBT-Moduls überwacht werden.

### Offenbarung der Erfindung

Die vorliegende Erfindung offenbart ein Schaltelement mit den Merkmalen des Patentanspruchs 1, ein Antriebssystem mit den Merkmalen des Patentanspruchs 6 und ein Verfahren zur Temperaturüberwachung mit den Merkmalen des Patentanspruchs 8.

### Demgemäß ist vorgesehen:

Ein Schaltelement mit einer Temperaturüberwachung, mit einem IGBT-Modul, einem ersten Temperatursensor, einem zweiten Temperatursensor, einem Stromsensor und einer Überwachungseinrichtung. Das IGBT-Modul umfasst eine erste Mehrzahl von IGBT-Chips und eine zweite Mehrzahl von IGBT-Chips. Die Kollektoranschlüsse der ersten Mehrzahl von IGBT-Chips sind mit einem ersten Anschluss des IGBT-Moduls elektrisch gekoppelt. Die Emitteranschlüsse der ersten Mehrzahl von IGBT-Chips sind mit einem Knotenpunkt des IGBT-Moduls elektrisch gekoppelt. Die Kollektoranschlüsse der zweiten Mehrzahl von IGBT-Chips sind mit dem Knotenpunkt des IGBT-Moduls elektrisch gekoppelt. Die Emitteranschlüsse der zweiten Mehrzahl von IGBT-Chips sind mit einem zweiten Anschluss des IGBT-Moduls elektrisch gekoppelt. Der erste Temperatursensor ist dazu ausgelegt, eine Chiptemperatur an einer ersten vorbestimmten Position des IGBT-Moduls zu erfassen. Der zweite Temperatursensor ist dazu ausgelegt, eine Umgebungstemperatur in der Umgebung des IGBT-Moduls zu erfassen. Der Stromsensor ist dazu ausgelegt, einen elektrischen Strom zu erfassen, der an dem Knotenpunkt des IGBT-Moduls in das IGBT-Modul hineinfließt. Die

Überwachungseinrichtung ist dazu ausgelegt, unter Verwendung des durch den Stromsensor erfassten elektrischen Stroms und der durch den zweiten Temperatursensor erfassten Umgebungstemperatur eine Grenztemperatur zu ermitteln. Ferner ist die Überwachungseinrichtung dazu ausgelegt, die ermittelte Grenztemperatur mit der durch den ersten Temperatursensor erfassten Chiptemperatur zu vergleichen. Basierend auf dem Vergleich der Grenztemperatur mit der Chiptemperatur kann eine Fehlfunktion in dem IGBT-Modul detektiert werden.

### Weiterhin ist vorgesehen:

Ein Antriebssystem mit einer elektrischen Maschine mit einer Mehrzahl von Phasenanschlüssen und einem Stromrichter mit einem erfindungsgemäßen Schaltelement. Insbesondere kann der Stromrichter für jeden Phasenanschluss der elektrischen Maschine ein erfindungsgemäßes Schaltelement aufweisen.

### Ferner ist vorgesehen:

Ein Verfahren zur Temperaturüberwachung eines IGBT-Moduls. Das IGBT-Modul umfasst dabei eine erste Mehrzahl von IGBT-Chips und eine zweite Mehrzahl von IGBT-Chips. Kollektoranschlüsse der ersten Mehrzahl von IGBT-Chips sind mit einem ersten Anschluss des IGBT-Moduls elektrisch gekoppelt, und die Emitteranschlüsse der ersten Mehrzahl von IGBT-Chips sind mit einem Knotenpunkt des IGBT-Moduls elektrisch gekoppelt. Die Kollektoranschlüsse der zweiten Mehrzahl von IGBT-Chips sind mit dem Knotenpunkt des IGBT-Moduls elektrisch gekoppelt, und die Emitteranschlüsse der zweiten Mehrzahl von IGBT-Chips sind mit einem zweiten Anschluss des IGBT-Moduls elektrisch gekoppelt. Das Verfahren umfasst die Schritte des Erfassens einer Chiptemperatur an einer vorbestimmten Position des IGBT-Moduls, das Erfassen einer Umgebungstemperatur in der Umgebung des IGBT-Moduls und des Erfassens eines elektrischen Stroms, der an einem Knotenpunkt des IGBT-Moduls in das IGBT-Modul hineinfließt. Das Verfahren umfasst ferner einen Schritt zum Ermitteln einer Grenztemperatur. Die Grenztemperatur wird dabei unter Verwendung des erfassten elektrischen Stroms und der erfassten Umgebungstemperatur ermittelt. Ferner umfasst das Verfahren einen Schritt zum Vergleichen der ermittelten Grenztemperatur mit der erfassten Chiptemperatur und einen Schritt zum Detektieren einer Fehlfunktion des IGBT-Moduls, wenn die erfasste Chiptemperatur die ermittelte Grenztemperatur übersteigt.

### Vorteile der Erfindung

Der vorliegenden Erfindung liegt die Erkenntnis zugrunde, dass beim Ausfall eines IGBT-Chips in einem IGBT-Modul mit einer Mehrzahl von parallelgeschalteten IGBT-Chips es zu einem Anstieg des elektrischen Stroms durch die verbleibenden intakten IGBT-Chips kommen kann. Ferner liegt der vorliegenden Erfindung die Erkenntnis zugrunde, dass ein solcher Anstieg des elektrischen Stroms durch die IGBT-Chips zu einer Beschädigung der intakten IGBT-Chips führen kann, wenn der elektrische Strom ein maximales zulässiges Maß überschreitet.

Es ist daher eine Idee der vorliegenden Erfindung, dieser Erkenntnis Rechnung zu tragen und eine Überwachung von Schaltelementen mit einem IGBT-Modul vorzusehen, die eine Überbeanspruchung einzelner IGBT-Chips in einem IGBT-Modul detektieren kann. Dabei liegt der vorliegenden Erfindung die Idee zugrunde, die Temperatur an einem solchen IGBT-Modul zu erfassen und die tatsächliche Temperatur an dem IGBT-Modul mit einem theoretischen Erwartungswert zu vergleichen. Zur Bestimmung dieses theoretischen Erwartungswerts für die Temperatur an dem IGBT-Modul kann ein Temperaturmodell erstellt werden. In dieses Temperaturmodell können beispielsweise Parameter wie die Umgebungstemperatur, die Strombelastung des IGBT-Moduls sowie gegebenenfalls die Temperatur eines Kühlmediums einfließen. Der theoretische Erwartungswert für die Temperatur des IGBT-Moduls an der Position des Temperatursensors kann dabei insbesondere auf Basis eines Kennlinienfeldes und/oder einer Mehrzahl von einzelnen Kennlinien ermittelt werden. Hierdurch kann die zu erwartende Temperatur an dem IGBT-Modul sehr einfach ohne eine aufwändige Rechenleistung ermittelt werden.

Durch den Vergleich der tatsächlichen Temperatur an dem IGBT-Modul mit einem theoretischen Erwartungswert kann ein unverhältnismäßiger Temperaturanstieg sehr einfach detektiert werden. Ein solcher Temperaturanstieg kann beispielsweise ein Indiz auf einem Fehlerzustand des IGBT-Moduls sein. Beispielsweise kann in einem solchen Fehlerzustand in einzelnen IGBT-Chips des IGBT-Moduls ein überproportional großer elektrischer Strom führen, der zu einem entsprechend überproportionalen Temperaturanstieg führt. Durch die erfindungsgemäße Temperaturüberwachung kann ein solcher unverhältnismäßig großer Temperaturanstieg frühzeitig erkannt werden. Hierdurch ist es möglich, Gegenmaßnahmen einzuleiten, bevor aufgrund eines thermischen Ereignisses es zu weiteren, gegebenenfalls starken Beschädigungen kommen kann.

Gemäß einer Ausführungsform umfasst das IGBT-Modul eine Kühleinrichtung. Diese Kühleinrichtung kann mittels eines Fluids gekühlt werden. Die Kühleinrichtung umfasst hierbei einen dritten Temperatursensor. Dieser dritte Temperatursensor ist dazu ausgelegt, eine Kühlmitteltemperatur des Fluids zu erfassen. Die Überwachungseinrichtung kann hierbei dazu ausgelegt sein, die Grenztemperatur zusätzlich unter Verwendung der erfassten Kühlmitteltemperatur zu ermitteln. Somit wird die Grenztemperatur mindestens basierend auf dem erfassten elektrischen Strom, der erfassten Umgebungstemperatur und der erfassten Kühlmitteltemperatur ermittelt. Auf diese Weise kann auch bei einer aktiven Kühlung eines IGBT-Moduls ein unverhältnismäßig großer Temperaturanstieg frühzeitig erkannt werden.

Gemäß einer weiteren Ausführungsform umfasst die Überwachungseinrichtung einen Speicher. Der Speicher ist dazu ausgelegt, ein vorbestimmtes Kennlinienfeld für die zu ermittelnde Grenztemperatur zu speichern. Dieses Kennlinienfeld kann den Zusammenhang zwischen der zu ermittelnden Grenztemperatur und den erfassten Parametern, wie insbesondere elektrischem Strom in das IGBT-Moduls, Umgebungstemperatur und gegebenenfalls Kühlmitteltemperatur spezifizieren. Sollen noch weitere Parameter in die Ermittlung der Grenztemperatur einfließen, so können auch diese über das gespeicherte Kennlinienfeld definiert werden. Das Kennlinienfeld kann dabei zuvor mittels theoretischer Simulation und/oder mittels Erfassung von Messwerten bestimmt und in der Speichereinrichtung abgespeichert werden. Bei der Speichereinrichtung kann es sich um einen beliebigen, nicht-flüchtigen Speicher handeln. Auf diese Weise kann die Grenztemperatur besonders einfach ermittelt werden.

Gemäß einer weiteren Ausführungsform ist die Überwachungseinrichtung dazu ausgelegt, die Grenztemperatur basierend auf einer in der Überwachungseinrichtung abgespeicherten vorbestimmten Funktion zu berechnen. Gegebenenfalls können auch mehrere alternative Funktionen für die Spezifikation der Grenztemperatur abgespeichert werden. Auf diese Weise kann ein speichereffizientes Verfahren für die Ermittlung der Grenztemperatur realisiert werden.

Gemäß einer weiteren Ausführungsform ist die Überwachungseinrichtung dazu ausgelegt, die Ermittlung der Grenztemperatur und den Vergleich der ermittelten Grenztemperatur mit der Chiptemperatur nur dann auszuführen, wenn sich ein an dem Knotenpunkt des IGBT-Moduls angeschlossene elektrische Maschine in einem vorbestimmten Betriebszustand befindet. Beispielsweise kann die Überwachungseinrichtung dazu ausgelegt sein, die erfindungsgemäße Temperaturüberwachung nur dann auszuführen, wenn sich eine angeschlossene elektrische Maschine in einem aktiven Kurzschluss befindet.

Gemäß einer weiteren Ausführungsform ist die Überwachungseinrichtung dazu ausgelegt, die Grenztemperatur unter Verwendung der Schaltzustände der IGBT-Chips in dem IGBT-Modul zu ermitteln. Insbesondere kann die Überwachungseinrichtung dabei bei einem aktiven Kurzschluss für eine angeschlossene elektrische Maschine unterscheiden, ob der aktive Kurzschluss hierbei mittels der ersten Mehrzahl von IGBT-Chips oder der zweiten Mehrzahl von IGBT-Chips realisiert wird. Auf diese Weise kann für einen sogenannten oberen aktiven Kurzschluss und einen sogenannten unteren aktiven Kurzschluss jeweils eine individuelle Grenztemperatur ermittelt werden.

Gemäß einer Ausführungsform des Antriebssystems umfasst das Antriebssystem eine Steuereinrichtung. Die Steuereinrichtung ist dazu ausgelegt, durch Ansteuern des Stromrichters die Phasenanschlüsse der angeschlossenen elektrischen Maschine kurzzuschließen und so einen aktiven Kurzschluss einzustellen. Insbesondere kann beispielsweise durch Ansteuern der ersten Mehrzahl von IGBT-Chips in dem IGBT-Modul ein oberer Kurzschluss eingestellt werden. Alternativ kann durch Ansteuern der zweiten Mehrzahl von IGBT-Chips in dem IGBT-Modul ein unterer Kurzschluss eingestellt werden. Die Überwachungseinrichtung kann dabei dazu ausgelegt sein, die Ermittlung der Grenztemperatur und den Vergleich der ermittelten Grenztemperatur mit der Chiptemperatur nur dann auszuführen, wenn die Phasenanschlüsse der elektrischen Maschine kurzgeschlossen sind. Dabei kann gegebenenfalls zwischen einem Kurzschluss mittels der ersten Mehrzahl von IGBT-Chips und einem Kurzschluss mittels der zweiten Mehrzahl von IGBT-Chips bei der Ermittlung der Grenztemperatur unterschieden werden.

Gemäß einer Ausführungsform des Verfahrens zur Temperaturüberwachung umfasst das Verfahren einen Schritt zum Erfassen einer Kühlmitteltemperatur eines Fluids, mit welchem das IGBT-Modul gekühlt wird. In dem Schritt zum Ermitteln der Grenztemperatur wird dabei die Grenztemperatur ferner unter Verwendung der erfassten Kühlmitteltemperatur ermittelt. Die Grenztemperatur wird somit mindestens unter Verwendung des in das IGBT-Modul hineinfließenden Stroms, der Umgebungstemperatur und der Kühlmitteltemperatur ermittelt.

Gemäß einer weiteren Ausführungsform wird die Grenztemperatur unter Verwendung eines zuvor bestimmten Kennlinienfeldes ermittelt.

Gemäß einer weiteren Ausführungsform wird in dem Schritt zum Ermitteln der Grenztemperatur die Grenztemperatur unter Berücksichtigung der Schaltzustände der IGBT-Chips in dem IGBT-Modul berücksichtigt. Insbesondere kann beispielsweise für die Ermittlung der Grenztemperatur eine Unterscheidung zwischen einer Ansteuerung für einen oberen aktiven Kurzschluss und einen unteren aktiven Kurzschluss berücksichtigt werden. Bei einem oberen aktiven Kurzschluss können beispielsweise alle Schaltelemente der ersten Mehrzahl von IGBT-Chips angesteuert werden, während bei einem unteren Kurzschluss alle IGBT-Chips der zweiten Mehrzahl von IGBT-Chips angesteuert werden.

Die obigen Ausgestaltungen und Weiterbildungen lassen sich, sofern sinnvoll, beliebig miteinander kombinieren. Weitere Ausgestaltungen, Weiterbildungen und Implementierungen der Erfindung umfassen auch nicht explizit genannte Kombinationen von zuvor oder im Folgenden bezüglich den Ausführungsbeispielen beschriebenen Merkmalen der Erfindung. Insbesondere wird der Fachmann dabei auch Einzelaspekte als Verbesserungen oder Ergänzungen zu der jeweiligen Grundform der vorliegenden Erfindung hinzufügen.

### Kurze Beschreibung der Zeichnungen

Die vorliegende Erfindung wird nachfolgend anhand der in den schematischen Figuren der Zeichnungen angegebenen Ausführungsbeispielen näher erläutert. Dabei zeigen:
- Figur 1:: eine schematische Darstellung eines Antriebssystems mit einem Wechselrichter gemäß einer Ausführungsform;
- Figur 2:: eine schematische Darstellung eines IGBT-Moduls für ein Schaltelement gemäß einer Ausführungsform;
- Figur 3:: eine schematische Darstellung eines Schaltelements mit einer Temperaturüberwachung gemäß einer Ausführungsform;
- Figur 4:: eine schematische Darstellung einer Draufsicht auf ein IGBT-Modul für ein Schaltelement gemäß einer Ausführungsform; und
- Figur 5:: eine schematische Darstellung eines Ablaufdiagramms, wie es einem Verfahren gemäß einer Ausführungsform zugrunde liegt.
Ausführungsformen der Erfindung

In allen Figuren sind gleiche bzw. funktionsgleiche Elemente und Vorrichtungen, soweit nicht anders angegeben, mit gleichen Bezugszeichen versehen.

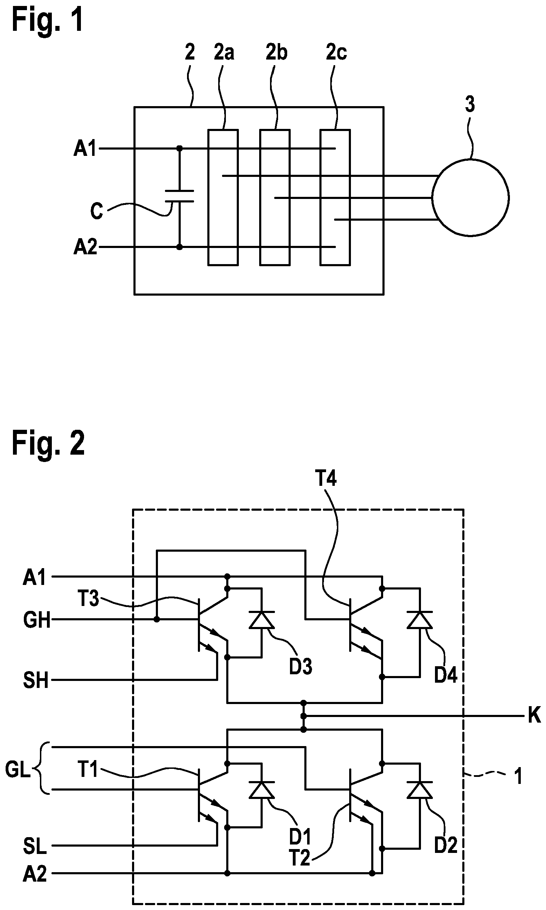

Figur 1 zeigt eine schematische Darstellung eines Blockschaltbilds für ein elektrisches Antriebssystem. Ein Wechselrichter 2 wird dabei an den Gleichspannungsanschlüssen A1 und A2 mit einer Gleichspannung versorgt. Neben einem Zwischenkreiskondensator C umfasst der Wechselrichter 2 drei Brückenzweige 2a, 2b, 2c. Die hier dargestellte Anzahl von drei Brückenzweigen dient dabei jedoch nur dem besseren Verständnis und stellt keine Beschränkung dar. Jeder Brückenzweig 2a, 2b, 2c kann dabei beispielsweise mittels eines IGBT-Moduls 1 realisiert werden. Gegebenenfalls können auch mehrere IGBT-Module parallel angeordnet werden. Am Ausgang des Wechselrichters 2 ist jeder Phasenanschluss der elektrischen Maschine 3 mit einem Brückenzweigs 2a, 2b, 2c elektrisch verbunden.

Figur 2 zeigt eine schematische Darstellung eines IGBT-Moduls 1, wie es beispielsweise in einem Brückenzweig 2a, 2b, 2c des Antriebssystems aus Figur 1 eingesetzt werden kann. Ein IGBT-Modul 1 kann beispielsweise zwischen einem oberen Anschlusspunkt A1 und einem Knotenpunkt K mehrere IGBT-Chips parallel angeordnet haben. Beispielsweise können, wie in Figur 2 dargestellt, zwei IGBT-Chips parallel angeordnet sein. Aber auch mehr als zwei IGBT-Chips, die parallel zueinander verschaltet sind, sind darüber hinaus möglich. Beispielsweise können auch drei, vier, fünf oder mehr IGBT-Chips parallel angeordnet sein. Jeder IGBT-Chip umfasst dabei einen bipolaren Transistor mit einem isolierten Gateanschluss. Die Kollektoranschlüsse der beiden Transistoren T4 und T3 der beiden IGBT-Chips sind dabei jeweils mit dem oberen Anschluss A1 des IGBT-Moduls 1 elektrisch verbunden. Die Emitteranschlüsse der beiden Transistoren T4 und T3 der IGBT-Chips sind mit dem Knotenpunkt K des IGBT-Moduls 1 elektrisch verbunden. Weiterhin sind auch die Gateanschlüsse gemeinsam an einem oberen Gateanschluss GH aus dem IGBT-Modul 1 herausgeführt. Gegebenenfalls kann zur Erfassung des elektrischen Stroms durch einen Transistor T4 eines IGBT-Chips auch ein sogenannter Sense-Anschluss SH des Transistors T3 nach außen geführt werden.

Analog sind auch mehrere IGBT-Chips zwischen dem Knotenpunkt K und dem unteren Anschluss A2 des IGBT-Moduls 1 vorgesehen. Auch hier ist die dargestellte Anzahl von zwei IGBT-Chips nur beispielhaft zu verstehen. In der Regel werden zwischen dem oberen Anschlusspunkt A1 und dem Knotenpunkt K eine gleiche Anzahl von IGBT-Chips vorgesehen, wie zwischen dem Knotenpunkt K und dem unteren Anschlusspunkt A2. Die Kollektoranschlüsse der unteren Transistoren T1 und T2 sind dabei mit dem Knotenpunkt K elektrisch verbunden. Die Emitteranschlüsse der unteren Transistoren T1 und T2 sind mit dem unteren Anschluss A2 elektrisch verbunden. Die Gateanschlüsse GL der beiden unteren Transistoren T1 und T2 können dabei gemeinsam oder separat aus dem IGBT-Modul 1 herausgeführt werden. Auch kann ein Sense-Anschluss SL eines unteren Transistors T1 zur Erfassung eines elektrischen Stroms durch den entsprechenden Transistor nach außen geführt werden.

Parallel zu jedem Transistor T1 bis T4 der einzelnen IGBT-Chips kann jeweils eine Diode D1 bis D4 vorgesehen sein.

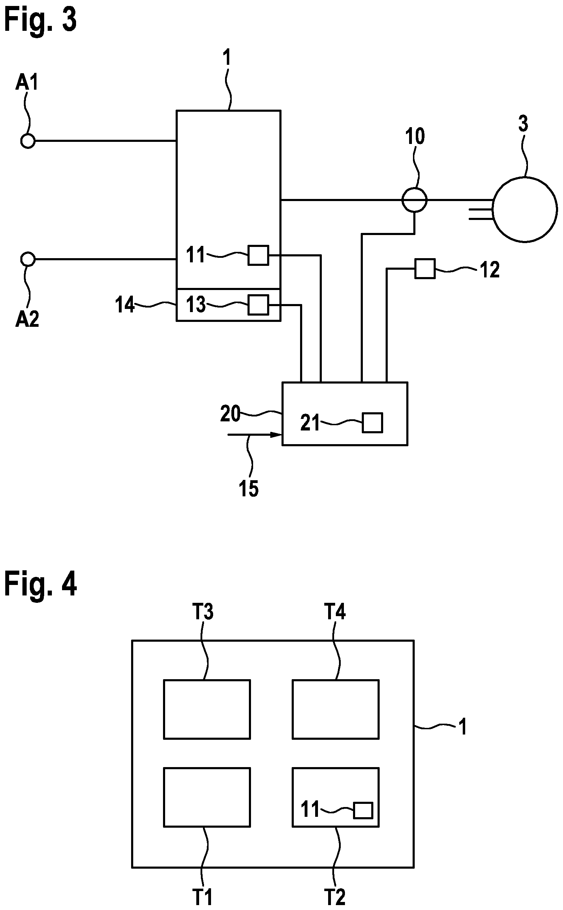

Figur 3 zeigt eine schematische Darstellung eines Schaltelements mit einer Temperaturüberwachung gemäß einer Ausführungsform. Das Schaltelement umfasst hierbei ein IGBT-Modul 1, beispielsweise ein im Zusammenhang mit Figur 2 beschriebenes IGBT-Modul 1. Zwischen dem ersten Anschluss A1 und dem Knotenpunkt K ist dabei eine erste Mehrzahl von IGBT-Chips parallel zueinander angeordnet. Zwischen dem Knoten K und dem zweiten Anschluss A2 des IGBT-Moduls 1 ist eine zweite Mehrzahl von IGBT-Chips parallel zueinander vorgesehen. Ein Stromsensor 10 erfasst dabei den elektrischen Strom zwischen dem Knotenpunkt K und einem Phasenanschluss der elektrischen Maschine 3. Bei diesem Stromsensor 10 kann es sich um einen beliebigen Stromsensor handeln, der ein zu dem erfassten elektrischen Strom korrespondierendes analoges oder digitales Ausgangssignal bereitstellt. Dieses zu dem elektrischen Strom korrespondiere Ausgangssignal wird an der Überwachungseinrichtung 20 bereitgestellt. Weiterhin ist an dem IGBT-Modul 1 ein erster Temperatursensor 11 vorgesehen. Dieser erste Temperatursensor 11 ist an einer bekannten, vorbestimmten Position an dem IGBT-Modul 1 angeordnet. Der erste Temperatursensor 11 erfasst die Temperatur an dieser vorgegebenen Position des IGBT-Moduls 1 und stellt ein zu dieser erfassten Temperatur korrespondierendes Ausgangssignal bereit. Bei diesem Ausgangssignal kann es sich um ein beliebiges analoges oder digitales Ausgangssignal handeln, das zu der durch den ersten Temperatursensor 11 erfassten Temperatur korrespondiert. Dieses Ausgangssignal wird ebenfalls an der Überwachungseinrichtung 20 bereitgestellt. Der erste Temperatursensor 11 kann dabei in dem IGBT-Modul 1 integriert sein, oder der erste Temperatursensor 11 kann auf das IGBT-Modul 1 aufgeschraubt, mit dem IGBT-Modul 1 verklebt oder auf andere Weise verbunden sein.

Weiterhin wird durch einen zweiten Temperatursensor 12 die Umgebungstemperatur in der Umgebung des IGBT-Moduls 1 erfasst. Insbesondere erfasst dabei der zweite Temperatursensor eine Temperatur an einer Position, die von dem IGBT-Modul 1 beabstandet ist. Der zweite Temperatursensor 12 liefert daraufhin ein zu der erfassten Umgebungstemperatur korrespondierendes analoges oder digitales Ausgangssignal, das an der Überwachungseinrichtung 20 bereitgestellt wird. Ferner kann das IGBT-Modul 1 mit einer Kühleinrichtung 14 thermisch gekoppelt werden, um das IGBT-Modul 1 zu entwärmen. Diese Kühleinrichtung 14 kann beispielsweise von einem Fluid durchströmt werden. Bei diesem Fluid kann es sich um eine beliebige flüssige oder gasförmige Substanz handeln. Beispielsweise ist eine Kühlung mittels Wasser oder ähnlichem möglich. Dabei kann die Temperatur des Kühlmediums, welches die Kühleinrichtung 14 durchströmt, mittels eines dritten Temperatursensors 13 erfasst werden. Der dritte Temperatursensor 13 stellt daraufhin ein analoges oder digitales Ausgangssignal bereit, das zu der erfassten Kühlmitteltemperatur korrespondiert. Dieses Ausgangssignal wird ebenfalls an der Überwachungseinrichtung 20 bereitgestellt. Ferner kann an der Überwachungseinrichtung 20 eine Information über die Ansteuersignale zum Ansteuern der einzelnen Transistoren in den IGBT-Chips des IGBT-Moduls 1 an der Überwachungseinrichtung 20 bereitgestellt werden.

Die Überwachungseinrichtung 20 empfängt das Ausgangssignal des Stromsensors 10, sowie der angeschlossenen Temperatursensoren 11-13 und die Information über die Ansteuersignale der IGBT-Chips in dem IGBT-Modul 1. Gegebenenfalls können auch noch weitere Informationen an der Überwachungseinrichtung 20 bereitgestellt und durch diese ausgewertet werden. Die Überwachungseinrichtung 20 bestimmt aus diesen Informationen eine an dem IGBT-Chip 1 zu erwartende Temperatur. Insbesondere wird durch die Überwachungseinrichtung 20 eine maximale Temperatur bestimmt, die sich an der Position einstellen wird, an der der erste Temperatursensor 11 angeordnet ist. Hierzu kann der elektrische Strom zwischen dem Knotenpunkt K und dem Phasenanschluss der elektrischen Maschine 3, die Umgebungstemperatur, sowie gegebenenfalls die Kühlmitteltemperatur und die Information über die Ansteuersignale der IGBT-Chips in dem IGBT-Modul 1 berücksichtigt werden. Basierend auf den Ansteuersignalen 15 für die IGBT-Chips in dem IGBT-Modul 1 kann bestimmt werden, durch welche IGBT-Chips der elektrische Strom fließen soll. Sind darüber hinaus noch Umgebungstemperatur und gegebenenfalls Kühlmitteltemperatur bekannt, so kann hieraus unter Berücksichtigung des Abstands der einzelnen IGBT-Chips zu dem ersten Temperatursensor 11 an dem IGBT-Modul 1 die sich im stationären Zustand einstellende Temperatur an der Position des ersten Temperatursensors 11 bestimmt werden. Eine Berechnung der sich im stationären Zustand einstellenden Temperatur kann beispielsweise basierend auf den dem Fachmann bekannten thermodynamischen Grundlagen berechnet werden. Beispielsweise kann unter Kenntnis der geometrischen Konfiguration der IGBT-Moduls 1 und der Anordnung des IGBT-Moduls 1 auf der Kühleinrichtung 14 eine mathematische Formel für die Berechnung der sich im stationären Zustand einstellenden Temperatur bestimmt werden. Alternativ ist es jedoch auch möglich, mittels theoretischer Simulation oder praktischer Messungen, beispielsweise unter Laborbedingungen, die sich im stationären Zustand am ersten Temperatursensor 11 einstellenden Temperaturen vorab zu bestimmen. Diese vorab bestimmten Temperaturen können daraufhin in geeigneter Weise in einem Speicher 21 der Überwachungseinrichtung 20 abgespeichert werden. Beispielsweise können die Zusammenhänge zwischen der sich im stationären Zustand an der Position des ersten Temperatursensors 11 einstellenden Temperatur in Abhängigkeit von dem durch den Stromsensor 10 erfassten elektrischen Strom, der Umgebungstemperatur, der Ansteuersignale 15 der IGBT-Chips und gegebenenfalls der Kühlmitteltemperatur als ein mehrdimensionales Kennlinienfeld oder mehrere Kennlinienfelder in dem Speicher 21 der Überwachungseinrichtung 20 abgespeichert werden. Die Überwachungseinrichtung 20 kann somit auf einfache Weise die zu erwartende Temperatur an der Position des ersten Temperatursensors 11 am IGBT-Modul 1 ermitteln. Gegebenenfalls kann hierbei auch eine Interpolation zwischen mehreren Punkten des in dem Speicher 21 abgespeicherten Kennlinienfelds für eine präzise Bestimmung der Temperatur ausgeführt werden.

Nachdem durch die Überwachungseinrichtung 20 eine Temperatur bestimmt worden ist, die an der Position des ersten Temperatursensors 11 am IGBT-Modul 1 ermittelt worden ist, kann diese ermittelte Temperatur mit der tatsächlichen durch den ersten Temperatursensor 11 erfassten Temperatur verglichen werden. Überschreitet die durch den ersten Temperatursensor 11 erfasste Temperatur dabei die zu erwartende Temperatur, so kann dies auf einen möglichen Fehler innerhalb des IGBT-Moduls 1 hinweisen. Gegebenenfalls kann hierbei zur Kompensation von Störeinflüssen und/oder Messtoleranzen für die zu erwartende Temperatur an der Position des ersten Temperatursensors 11 ein zusätzlicher Schwellwert hinzuaddiert werden und diese Summe für die weitere Auswertung genutzt werden. Alternativ kann auch erst ein Fehler in dem IGBT-Modul 1 detektiert werden, wenn die durch den ersten Temperatursensor 11 erfasste Temperatur den ermittelten zu erwartenden Temperaturwert um mehr als einen vorgegebenen Schwellwert überschreitet. Überschreitet die durch den ersten Temperatursensor 11 erfasste Temperatur, wie zuvor beschrieben, die zu erwartende Temperatur bzw. überschreitet die erfasste Temperatur die zu erwartende Temperatur um mehr als einen Schwellwert, so wird ein Fehler in dem IGBT-Modul 1 detektiert. Daraufhin kann gegebenenfalls durch die Überwachungseinrichtung 20 eine Fehlermeldung ausgegeben werden.

Bei der Detektion eines Fehlers in dem IGBT-Modul 1 können daraufhin unmittelbar weitere Maßnahmen eingeleitet werden, um einen weiteren Temperaturanstieg zu vermeiden und gegebenenfalls eine Beschädigung durch ein thermisches Ereignis zu vermeiden. Beispielsweise kann die Ansteuerung der IGBT-Chips in dem IGBT-Modul 1 angepasst werden, um einen alternativen Schaltzustand einzustellen.

Beispielsweise können durch Ansteuern der IGBT-Chips in dem IGBT-Modul 1 die Transistoren in den IGBT-Chips derart angesteuert werden, dass die Phasenanschlüsse einer angeschlossenen elektrischen Maschine 3 kurzgeschlossen werden. Hierdurch kann ein aktiver Kurzschluss (AKS) eingestellt werden. Ein solcher aktiver Kurzschluss kann alternativ entweder durch Schließen der oberen IGBT-Chips zwischen dem ersten Anschlusspunkt A1 und dem Knotenpunkt K erreicht werden (oberer AKS) oder alternativ durch Schließen der IGBT-Chips zwischen dem Knotenpunkt K und dem zweiten Anschlusspunkt A2 (unterer AKS). Beispielsweise könnte, wenn sich während eines oberen AKS eine unzulässige Temperaturerhöhung einstellt, alternativ ein unterer AKS eingestellt werden. Umgekehrt könnte auch bei einer unzulässigen Temperaturerhöhung eines unteren AKS ein oberer AKS eingestellt werden.

Da der maximale elektrische Strom während eines aktiven Kurzschluss zu der Drehzahl der angeschlossenen elektrischen Maschine 3 korrespondiert, kann auch bei einer Detektion einer Temperaturerhöhung über den durch die Überwachungseinrichtung 20 ermittelten Temperaturwert während eines weiteren Betriebs die maximale Drehzahl der elektrischen Maschine 3 eingeschränkt werden. Insbesondere wenn es sich bei der elektrischen Maschine 3 um eine elektrische Maschine handelt, die mit dem Antriebssystem eines Hybridfahrzeugs oder ähnlichem gekoppelt ist, kann beispielsweise während des Antriebs des Hybridfahrzeugs mittels eines Verbrennungsmotors die maximale Drehzahl und somit die maximale Geschwindigkeit begrenzt werden, um gegebenenfalls bei einem erforderlichen aktiven Kurzschluss den sich maximal einstellenden Strom zu begrenzen.

Figur 4 zeigt eine schematische Darstellung einer Draufsicht auf ein IGBT-Modul 1 mit einem ersten Temperatursensor 11 gemäß einer Ausführungsform. Wie hierbei zu erkennen ist, weisen die einzelnen IGBT-Chips mit den vier Transistoren T1 bis T4 unterschiedliche Abstände zu dem ersten Temperatursensor 11 auf. Im thermodynamischen Gleichgewicht werden daher an der Position des ersten Temperatursensors 11 unterschiedliche maximale Temperaturen auftreten, je nachdem durch welche Transistoren T1 -T4 der IGBT-Chips ein elektrischer Strom fließen wird. Aus diesem Grund sind bei der Ermittlung der zu erwartenden Temperatur an der Position des Temperatursensors 11 auch die Schaltzustände bzw. die Ansteuersignale für die IGBT-Chips mit zu berücksichtigen.

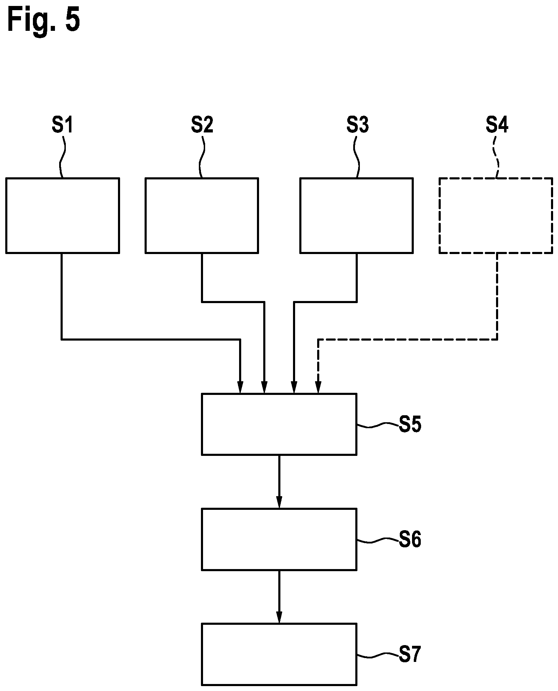

Figur 5 zeigt eine schematische Darstellung eines Ablaufdiagramms, wie es einem Verfahren zur Temperaturüberwachung eines IGBT-Moduls 1 zugrunde liegt. Bei dem IGBT-Modul 1 kann es sich dabei insbesondere um ein zuvor beschriebenes IGBT-Modul 1 mit einer Mehrzahl von IGBT-Chips handeln. In Schritt S1 wird eine Chiptemperatur an einer vorbestimmten Position des IGBT-Moduls 1 erfasst. Diese Chiptemperatur kann beispielsweise durch einen zuvor beschriebenen ersten Temperatursensor erfasst werden. In Schritt S2 wird eine Umgebungstemperatur in der Umgebung des IGBT-Moduls 1 erfasst. Diese Umgebungstemperatur kann beispielsweise durch den zweiten Temperatursensor 12 erfasst werden. In einem Schritt S3 wird ein elektrischer Strom an einem Knotenpunkt des IGBT-Moduls 1 in das IGBT-Modul 1 hinein erfasst. Beispielsweise kann dieser elektrische Strom durch den Stromsensor 10 erfasst werden. Bei diesem erfassten elektrischen Strom kann es sich beispielsweise um einen elektrischen Strom zwischen dem Knotenpunkt K und einem Phasenanschluss einer angeschlossenen elektrischen Maschine 3 handeln. In einem weiteren Schritt S4 kann beispielsweise mittels eines dritten Temperatursensors 13, eine Kühlmitteltemperatur eines Fluids erfasst werden, welches das IGBT-Modul 1 kühlt. In Schritt S5 wird unter Verwendung der erfassten Parameter wie erfasster elektrischer Strom, erfasste Umgebungstemperatur und gegebenenfalls erfasster Kühlmitteltemperatur eine Grenztemperatur ermittelt. Bei der Ermittlung der Grenztemperatur können darüber hinaus auch Ansteuersignale für die Ansteuerung der IGBT-Chips in dem IGBT-Modul 1 mit berücksichtigt werden. In Schritt S6 wird die ermittelte Grenztemperatur mit der erfassten Chiptemperatur verglichen und daraufhin in Schritt S7 eine Fehlfunktion des IGBT-Moduls 1 detektiert, wenn die erfasste Chiptemperatur die ermittelte Grenztemperatur übersteigt. Gegebenenfalls kann auch erst dann eine Fehlfunktion des IGBT-Moduls 1 detektiert werden, wenn die erfasste Chiptemperatur die ermittelte Grenztemperatur um mehr als einen vorgegebenen Schwellwert übersteigt.

Bei der Detektion einer Fehlfunktion kann eine Fehlermeldung ausgegeben werden. Gegebenenfalls können daraufhin die Ansteuersignale für die Ansteuerung der IGBT-Chips in dem IGBT-Modul 1 angepasst werden und/oder eine maximale Drehzahl einer an das IGBT-Modul 1 angeschlossenen elektrischen Maschine 3 kann auf eine vorgegebene maximale Drehzahl begrenzt werden.

Zusammenfassend betrifft die vorliegende Erfindung eine Temperaturüberwachung für Schaltelemente insbesondere für ein Modul mit bipolaren Transistoren mit einem isolierten Gate. Hierzu werden die aktuellen Betriebsparameter des IGBT-Moduls erfasst und basierend auf diesen Betriebsparametern eine zu erwartende Temperatur des Schaltelements an einer vorgegebenen Position bestimmt. Diese zu erwartende Temperatur wird mit einer an dieser Position erfassten Temperatur verglichen. Überschreitet die tatsächliche Temperatur die zu erwartende Temperatur, so ist dies ein Hinweis auf eine Fehlfunktion.

## Patentansprüche

1. Schaltelement mit einer Temperaturüberwachung, mit:
einem IGBT-Modul (1), umfassend einen ersten Anschluss (A1) und einen zweiten Anschluss (A2) sowie einen Knotenpunkt (K), eine erste Mehrzahl von IGBT-Chips und eine zweite Mehrzahl von IGBT-Chips, wobei die IGBT-Chips der ersten Mehrzahl und der zweiten Mehrzahl von IGBT-Chips jeweils Kollektor- und Emitter-Anschlüsse aufweisen und wobei die Kollektor-Anschlüsse der ersten Mehrzahl von IGBT-Chips mit dem einem ersten Anschluss (A1) des IGBT-Moduls (1) elektrisch gekoppelt sind und die Emitter-Anschlüsse der ersten Mehrzahl von IGBT-Chips mit dem Knotenpunkt (K) elektrisch gekoppelt sind, und wobei die Kollektor-Anschlüsse der zweiten Mehrzahl von IGBT-Chips mit dem Knotenpunkt (K) elektrisch gekoppelt sind und die Emitter-Anschlüsse der zweiten Mehrzahl von IGBT-Chips mit dem zweiten Anschluss (A2) des IGBT-Moduls (1) elektrisch gekoppelt sind;
einem ersten Temperatursensor (11), der dazu ausgelegt ist, eine Chiptemperatur an einer vorbestimmten Position des IGBT-Moduls (1) zu erfassen;
einem zweiten Temperatursensor (12), der dazu ausgelegt ist, eine Umgebungstemperatur in der Umgebung des IGBT-Moduls (1) zu erfassen;
einem Stromsensor (10), der dazu ausgelegt ist, einen elektrischen Strom zu erfassen, der an dem Knotenpunkt (K) des IGBT-Moduls (1) in das IGBT-Modul (1) hineinfließt; und
einer Überwachungseinrichtung (20), die dazu ausgelegt ist, unter Verwendung des durch den Stromsensor (10) erfassten elektrischen Stroms und der durch den zweiten Temperatursensor (12) erfassten Umgebungstemperatur eine Grenztemperatur zu ermitteln, und
basierend auf einem Vergleich der ermittelten Grenztemperatur mit der durch den ersten Temperatursensor (11) erfassten Chiptemperatur eine Fehlfunktion des IGBT-Moduls (1) zu detektieren.

2. Schaltelement nach Anspruch 1, wobei das IGBT-Modul (1) eine Kühleinrichtung (14) umfasst, die mittels eines Fluids gekühlt werden kann, wobei die Kühleinrichtung (14) einen dritten Temperatursensor (13) umfasst, der dazu ausgelegt ist, eine Kühlmittel-Temperatur des Fluids zu erfassen; und
wobei die Überwachungseinrichtung (20) ferner dazu ausgelegt ist, die Grenztemperatur unter Verwendung der erfassten Kühlmittel-Temperatur zu ermitteln.

3. Schaltelement nach Anspruch 1 oder 2, wobei die Überwachungseinrichtung (20) einen Speicher (21) umfasst, der dazu ausgelegt ist, ein vorbestimmtes Kennlinienfeld für die zu ermittelnde Grenztemperatur in Abhängigkeit von Strom in das IGBT-Modul (1), Umgebungstemperatur und/oder Kühlmitteltemperatur zu speichern.

4. Schaltelement nach einem der Ansprüche 1 bis 3, wobei die Überwachungseinrichtung (20) dazu ausgelegt ist, die Grenztemperatur basierend auf einer in der Überwachungseinrichtung (20) gespeicherten vorbestimmten Funktion zu berechnen.

5. Schaltelement nach einem der Ansprüche 1 bis 4, wobei die Überwachungseinrichtung (20) dazu ausgelegt ist, die Ermittlungen der Grenztemperatur und den Vergleich der ermittelten Grenztemperatur mit der Chiptemperatur nur dann auszuführen, wenn sich eine an dem Knotenpunkt (K) des IGBT-Moduls (1) angeschlossene elektrische Maschine (3) in einem vorbestimmten Betriebszustand befindet.

6. Antriebssystem, mit:
einer elektrischen Maschine (3) mit einer Mehrzahl von Phasenanschlüssen;
einem Stromrichter (2), mit einem Schaltelement nach einem der Ansprüche 1 bis 5.

7. Antriebssystem nach Anspruch 6, mit einer Steuereinrichtung, die dazu ausgelegt ist durch Ansteuern des Stromrichters (2) in einem aktiven Kurzschluss die Phasenanschlüsse elektrischen Maschine (3) kurzzuschließen;
wobei die Überwachungseinrichtung (20) dazu ausgelegt ist, die Ermittlung der Grenztemperatur und den Vergleich der ermittelten Grenztemperatur mit der Chiptemperatur nur dann auszuführen, wenn die Phasenanschlüsse der elektrischen Maschine (3) kurzgeschlossen sind.

8. Verfahren zur Temperaturüberwachung eines IGBT-Moduls (1) mit einer ersten Mehrzahl von IGBT-Chips und einer zweiten Mehrzahl von IGBT-Chips, wobei die Kollektor-Anschlüsse der ersten Mehrzahl von IGBT-Chips mit einem ersten Anschluss (A1) des IGBT-Moduls (1) elektrisch gekoppelt sind und die Emitter-Anschlüsse der ersten Mehrzahl von IGBT-Chips mit einem Knotenpunkt (K) elektrisch gekoppelt sind, und wobei die Kollektor-Anschlüsse der zweiten Mehrzahl von IGBT-Chips dem Knotenpunkt (K) elektrisch gekoppelt sind und die Emitter-Anschlüsse der zweiten Mehrzahl von IGBT-Chips mit einem zweiten Anschluss (A2) des IGBT-Moduls (1) elektrisch gekoppelt sind, mit den Schritten:
Erfassen (S1) einer Chiptemperatur an einer vorbestimmten Position des IGBT-Moduls (1);
Erfassten (S2) einer Umgebungstemperatur in der Umgebung des IGBT-Moduls (1);
Erfassen (S3) eines elektrischen Stroms, der an dem Knotenpunkt (K) des IGBT-Moduls (1) in das IGBT-Modul (1) hineinfließt;
Ermitteln (S5) einer Grenztemperatur unter Verwendung des erfassten elektrischen Stroms und der erfassten Umgebungstemperatur;
Vergleichen (S6) der ermittelten Grenztemperatur mit der erfassten Chiptemperatur; und
Detektieren (S7) einer Fehlfunktion des IGBT-Moduls (1), wenn die erfasste Chiptemperatur die ermittelte Grenztemperatur übersteigt.

9. Verfahren nach Anspruch 8, mit einem Schritt (S4) zum Erfassen einer Kühlmitteltemperatur eines Fluids, mit welchem das IGBT-Modul (1) gekühlt wird;
wobei der Schritt (S5) zum Ermitteln der Grenztemperatur die Grenztemperatur ferner unter Verwendung der erfassten Kühlmitteltemperatur ermittelt.

10. Verfahren nach Anspruch 8 oder 9, wobei die Grenztemperatur unter Verwendung eines zuvor bestimmten Kennlinienfeldes ermittelt wird.

## Claims

1. Switching element having temperature monitoring, including:
an IGBT module (1) comprising a first terminal (A1) and a second terminal (A2) and also a node (K), a first plurality of' IGBT chips and a second plurality of IGBT chips, wherein the IGBT chips of the first plurality and of the second plurality of IGBT chips in each case have collector terminals and emitter terminals and wherein the collector terminals of the first plurality of IGBT chips are electrically coupled to the first terminal (A1) of the IGBT module (1), and the emitter terminals of the first plurality of IGBT chips are electrically coupled to the node (K), and wherein the collector terminals of the second plurality of IGBT chips are electrically coupled to the node (K), and the emitter terminals of the second plurality of IGBT chips are electrically coupled to the second terminal (A2) of the IGBT module (1);
a first temperature sensor (11) which is designed to detect a chip temperature at a predetermined position of the IGBT module (1);
a second temperature sensor (12) which is designed to detect an ambient temperature in the vicinity of the IGBT module (1);
a current sensor (10) which is designed to detect an electric current which flows into the IGBT module (1) at the node (K) of the IGBT module (1); and
a monitoring device (20) which is designed to ascertain a limit temperature, using the electric current detected via the current sensor (10) and the ambient temperature detected via the second temperature sensor (12), and
to detect a malfunction of the IGBT module (1), based on a comparison of the ascertained limit temperature to the chip temperature detected via the first temperature sensor (11).

2. Switching element according to Claim 1, wherein the IGBT module (1) comprises a cooling device (14) which may be cooled by means of a fluid, wherein the cooling device (14) comprises a third temperature sensor (13) which is designed to detect a coolant temperature of the fluid; and
wherein the monitoring device (20) is furthermore designed to ascertain the limit temperature, using the detected coolant temperature.

3. Switching element according to Claim 1 or 2, wherein the monitoring device (20) comprises a memory (21) which is designed to store a predetermined set of characteristic curves for the limit temperature to be ascertained, as a function of current flowing into the IGBT module (1), ambient temperature, and/or coolant temperature.

4. Switching element according to one of Claims 1 to 3, wherein the monitoring device (20) is designed to calculate the limit temperature, based on a predetermined function which is stored in the monitoring device (20).

5. Switching element according to one of Claims 1 to 4, wherein the monitoring device (20) is designed to carry out the ascertainments of the limit temperature and the comparison of the ascertained limit temperature to the chip temperature only if an electric machine (3) which is connected to the node (K) of the IGBT module (1) is in a predefined operating state.

6. Drive system, including:
an electric machine (3) having a plurality of phase terminals;
a rectifier (2) including a switching element according to one of Claims 1 to 5.

7. Drive system according to Claim 6, including a control device which is designed to short-circuit the phase terminals of the electric machine (3) by controlling the rectifier (2) in an active short circuit;
wherein the monitoring device (20) is designed to carry out the ascertainment of the limit temperature and the comparison of the ascertained limit temperature to the chip temperature only if the phase terminals of the electric machine (3) are short-circuited.

8. Method for monitoring the temperature of an IGBT module (1) including a first plurality of IGBT chips and a second plurality of IGBT chips, wherein the collector terminals of the first plurality of IGBT chips are electrically coupled to a first terminal (A1) of the IGBT module (1), and the emitter terminals of the first plurality of IGBT chips are electrically coupled to a node (K), and wherein the collector terminals of the second plurality of IGBT chips are electrically coupled to the node (K), and the emitter terminals of the second plurality of IGBT chips are electrically coupled to a second terminal (A2) of the IGBT module (1), including the following steps:
detecting (S1) a chip temperature at a predetermined position of the IGBT module (1);
detecting (S2) an ambient temperature in the vicinity of the IGBT module (1);
detecting (S3) an electric current which flows into the IGBT module (1) at the node (K) of the IGBT module (1);
ascertaining (S5) a limit temperature, using the detected electric current and the detected ambient temperature;
comparing (S6) the ascertained limit temperature to the detected chip temperature; and
detecting (S7) a malfunction of the IGBT module (1) if the detected chip temperature exceeds the ascertained limit temperature.

9. Method according to Claim 8, having a step (S4) for detecting a coolant temperature of a fluid via which the IGBT module (1) is cooled;
wherein the step (S5) for ascertaining the limit temperature furthermore ascertains the limit temperature, using the detected coolant temperature.

10. Method according to Claim 8 or 9, wherein the limit temperature is ascertained using a previously determined set of characteristic curves.

## Revendications

1. Élément de commutation doté d'une surveillance de température, comprenant :
un module IGBT (1), comprenant une première borne (A1) et une deuxième borne (A2) ainsi qu'un point nodal (K), une première pluralité de puces d'IGBT et une deuxième pluralité de puces d'IGBT, les puces d'IGBT de la première pluralité et de la deuxième pluralité de puces d'IGBT possédant respectivement des bornes de collecteur et d'émetteur et les bornes de collecteur de la première pluralité de puces d'IGBT étant couplées électriquement à la première borne (A1) du module IGBT (1) et les bornes d'émetteur de la première pluralité de puces d'IGBT étant couplées électriquement au point nodal (K), et les bornes de collecteur de la deuxième pluralité de puces d'IGBT étant couplées électriquement au point nodal (K) et les bornes d'émetteur de la deuxième pluralité de puces d'IGBT étant couplées électriquement à la deuxième borne (A2) du module IGBT (1) ;
une première sonde de température (11), qui est conçue pour détecter une température de puce à une position prédéterminée du module IGBT (1) ;
une deuxième sonde de température (12), qui est conçue pour détecter une température ambiante dans l'environnement du module IGBT (1) ;
un capteur de courant (10), qui est conçu pour détecter le courant électrique qui pénètre dans le module IGBT (1) au niveau du point nodal (K) du module IGBT (1) ; et
un dispositif de surveillance (20), qui est conçu pour déterminer une température limite en utilisant le courant électrique détecté par le capteur de courant (10) et la température ambiante détectée par la deuxième sonde de température (12), et en se basant sur une comparaison de la température limite déterminée à la température de puce détectée par la première sonde de température (11), pour détecter un défaut de fonctionnement du module IGBT (1).

2. Élément de commutation selon la revendication 1, le module IGBT (1) comportant un dispositif de refroidissement (14) qui peut être refroidi au moyen d'un fluide, le dispositif de refroidissement (14) comprenant une troisième sonde de température (13) qui est conçue pour détecter une température de réfrigérant du fluide ; et
le dispositif de surveillance (20) étant en outre conçu pour déterminer la température limite en utilisant la température de réfrigérant détectée.

3. Élément de commutation selon la revendication 1 ou 2, le dispositif de surveillance (20) comprenant une mémoire (21) qui est conçue pour mémoriser un diagramme caractéristique prédéterminé pour la température limite à déterminer en fonction du courant dans le module IGBT (1), de la température ambiante et/ou de la température de réfrigérant.

4. Élément de commutation selon l'une des revendications 1 à 3, le dispositif de surveillance (20) étant conçu pour calculer la température limite en se basant sur une fonction prédéterminée mémorisée dans le dispositif de surveillance (20).

5. Élément de commutation selon l'une des revendications 1 à 4, le dispositif de surveillance (20) étant conçu pour effectuer les déterminations de la température limite et la comparaison de la température limite déterminée avec la température de puce uniquement lorsqu'une machine électrique (3) raccordée au point nodal (K) du module IGBT (1) se trouve dans un état opérationnel prédéterminé.

6. Système d'entraînement comprenant :
une machine électrique (3) ayant une pluralité de bornes de phase ;
un convertisseur statique (2) doté d'un élément de commutation selon l'une des revendications 1 à 5.

7. Système d'entraînement selon la revendication 6, comprenant un dispositif de commande qui est conçu pour court-circuiter les bornes de phase de la machine électrique (3) en pilotant le convertisseur statique (2) en un court-circuit actif ;
le dispositif de surveillance (20) étant conçu pour effectuer la détermination de la température limite et la comparaison de la température limite déterminée avec la température de puce uniquement lorsque les bornes de phase de la machine électrique (3) sont court-circuitées.

8. Procédé de surveillance de la température d'un module IGBT (1), comprenant une première pluralité de puces d'IGBT et une deuxième pluralité de puces d'IGBT, les bornes de collecteur de la première pluralité de puces d'IGBT étant couplées électriquement à une première borne (A1) du module IGBT (1) et les bornes d'émetteur de la première pluralité de puces d'IGBT étant couplées électriquement à un point nodal (K), et les bornes de collecteur de la deuxième pluralité de puces d'IGBT étant couplées électriquement au point nodal (K) et les bornes d'émetteur de la deuxième pluralité de puces d'IGBT étant couplées électriquement à une deuxième borne (A2) du module IGBT (1), comprenant les étapes suivantes :
détection (S1) d'une température de puce à une position prédéterminée du module IGBT (1) ;
détection (S2) d'une température ambiante dans l'environnement du module IGBT (1) ;
détection (S3) d'un courant électrique qui pénètre dans le module IGBT (1) au niveau du point nodal (K) du module IGBT (1) ;
détermination (S5) d'une température limite en utilisant le courant électrique détecté et la température ambiante détectée ;
comparaison (S6) de la température limite déterminée à la température de puce détectée ; et
détection (S7) d'un défaut de fonctionnement du module IGBT (1) lorsque la température de puce détectée dépasse la température limite déterminée.

9. Procédé selon la revendication 8, comprenant une étape (S4) de détection d'une température de réfrigérant d'un fluide avec lequel le module IGBT (1) est refroidi ; l'étape de détermination (S5) de la température limite déterminant la température limite en plus en utilisant la température de réfrigérant détectée.

10. Procédé selon la revendication 8 ou 9, la température limite étant déterminée en utilisant un diagramme caractéristique préalablement défini.
